# FASCICULE DE BREVET EUROPEEN

(11) **EP 3 792 982 B1**
(45) Date de publication et mention de la délivrance du brevet: **26.10.2022**
(21) Numéro de dépôt: 20195403.9
(22) Date de dépôt: 10.09.2020
(51) Int. Cl.: H01L 29/872, H01L 29/861, H01L 29/06, H01L 29/205, H01L 21/329, H01L 29/40, H01L 29/20

(54) **DISPOSITIF ELECTRONIQUE DE PUISSANCE A SUPER-JONCTION**
ELEKTRONISCHE LEISTUNGSVORRICHTUNG MIT SUPERJUNCTION
ELECTRONIC POWER DEVICE WITH SUPER-JUNCTION

(30) Priorité: 12.09.2019 FR 1910069
(43) Date de publication de la demande: 17.03.2021
(73) Titulaire: Commissariat à l'Energie Atomique et aux Energies Alternatives, 75015 Paris (FR)
(72) Inventeur: BUCKLEY, Julien, 38054 GRENOBLE CEDEX 9 (FR); BISCARRAT, Jérôme, 38054 GRENOBLE CEDEX 9 (FR)
(74) Mandataire: Cabinet Camus Lebkiri

(56) Documents cités:
- CN-A- 104 617 160
- US-A1- 2005 218 431
- US-A1- 2005 242 411
- US-B2- 9 991 335
- FUJIHIRA T: "THEORY OF SEMICONDUCTOR SUPERJUNCTION DEVICES", JAPANESE JOURNAL OF APPLIED PHYSICS, JAPAN SOCIETY OF APPLIED PHYSICS, JP, vol. 36, no. 10, 1 octobre 1997 (1997-10-01), pages 6254-6262, XP000918328, ISSN: 0021-4922, DOI: 10.1143/JJAP.36.6254

## Description

### DOMAINE TECHNIQUE DE L'INVENTION

Le domaine technique de l'invention est celui de l'électronique de puissance.

La présente invention concerne les circuits électroniques intégrés et en particulier des composants électroniques intégrés capables de résister à des surcharges électriques.

### ARRIERE-PLAN TECHNOLOGIQUE DE L'INVENTION

La diode est un composant classique de l'électronique de puissance car elle permet la mise en œuvre de fonctions de base telles que la commutation, le redressement, la division de tension, etc.

Il est donc particulièrement avantageux dans le domaine de l'électronique de puissance que les diodes présentent une grande vitesse de commutation, une faible résistivité à l'état passant, c'est-à-dire une forte intensité de courant à l'état passant, ainsi qu'une tension de claquage élevée.

Cela étant, la résistivité d'une diode à l'état passant dépend du matériau de la diode qui définit également la tension de claquage de la diode. Le niveau de tension converti par la fonction de commutation est limité par la tension de claquage de la diode.

Il existe des architectures de diode dites « diodes MPS » (« Merged PiN Schottky » selon l'acronyme anglo-saxon), ou diode à surcharge, comportant un premier type de diode, par exemple une diode PIN (« Positive Intrinsic Negative », selon l'acronyme anglo-saxon), et un deuxième type de diode, par exemple une diode Schottky, couplées en parallèle. Cette architecture permet à la fois une commutation rapide entre les états bloqué et passant, et supporte des surcharges de courant apparaissant notamment en régime transitoire. Cela étant, ces diodes présentent un coût élevé du fait qu'elles sont généralement réalisées à partir d'un substrat en nitrure de gallium (GaN).

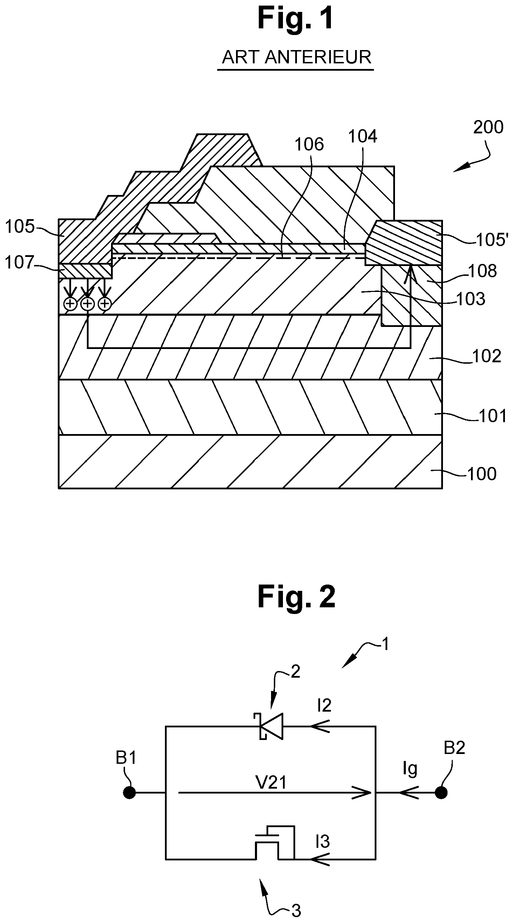

[Fig. 1] Le brevet japonais publié sous le numéro JP2015198175 décrit un exemple de diode MPS comportant une diode Schottky à hétérojonction montée en parallèle avec une diode PIN et dont une vue en coupe schématique est reproduite sur la figure 1.

Une hétérojonction est formée par la jonction de deux couches de matériaux semi-conducteurs ayant des bandes interdites différentes. Un gaz bidimensionnel d'électrons se forme à l'interface entre les deux couches de matériau semi-conducteurs du fait d'une polarisation spontanée et d'une polarisation piézoélectrique. Ce gaz bidimensionnel sert de canal de conduction au sein des composants électroniques à hétérojonction, et permet une forte densité de courant en raison de sa grande densité de porteurs de charge.

La diode MPS 200 de l'art antérieur comporte un substrat semi-conducteur 100, ou substrat porteur, sur lequel est réalisée une couche tampon 101. Une couche tampon permet classiquement de limiter les courants de fuite latéraux et verticaux dans le composant et de mieux confiner le gaz bidimensionnel d'électrons au niveau de l'interface de l'hétérojonction.

La diode MPS 200 comporte en outre une couche semi-conductrice intrinsèque 102, c'est-à-dire une couche semi-conductrice non intentionnellement dopée, sur laquelle est réalisée l'hétérojonction. L'hétérojonction comporte une couche de nitrure de gallium (GaN) 103, une couche de nitrure d'aluminium-galium (AlGaN) 104 et un gaz bidimensionnel d'électrons 106 formé à l'interface entre la couche de GaN 103 et la couche de AlGaN 104.

La diode Schottky comporte une première électrode 105 en contact Schottky avec le gaz d'électrons 106, formant l'anode de la diode Schottky, et une deuxième électrode 105' en contact ohmique avec le gaz d'électrons 106 et formant la cathode de la diode Schottky.

La diode PIN comporte une première région implantée de type P 107 réalisée dans la couche de nitrure de galium 103 et formant l'anode de la diode PIN, la couche intrinsèque 102 et une deuxième région implantée de type N 108 réalisée dans la couche de nitrure de galium 103, dans la couche intrinsèque 102 et formant la cathode de la diode PIN.

D'après le document JP2015198175, une solution pour améliorer le courant à l'état passant de la diode de type MPS 200 consiste à doper légèrement la couche semiconductrice intrinsèque 102 de la diode PIN. Cela étant, l'augmentation du dopage de la zone intrinsèque diminue la valeur de la tension de claquage de la diode. Notamment, à partir d'un certain seuil de dopage, lorsque l'on multiplie par dix la valeur de dopage de la couche semi-conductrice 102, la valeur de la tension de claquage est divisée par dix.

Il existe donc un besoin d'une diode ayant une vitesse de commutation élevée, une valeur de courant à l'état passant élevée et une tension de claquage élevée.

Par ailleurs, le document CN104617160 (5TH ELECTRONIC RES INST MIIT, 13/05/2015) décrit un diode Schottky à base de GaN capable de tenir une tension élevée en polarisation inverse et de supporter un courant élevé en polarisation directe. La diode Schottky comprend successivement un substrat, une couche tampon, une super-jonction, une couche de canal en GaN et une couche barrière. Elle comprend en outre une anode et une cathode, en contact à la fois avec le gaz bidimensionnel d'électrons de l'hétérojonction et avec la super-jonction. La super-jonction est formée par une alternance de couches en GaN dopées n et dopées p.

### RESUME DE L'INVENTION

L'invention offre une solution aux problèmes évoqués précédemment en proposant un dispositif électronique intégré permettant le passage d'un courant électrique élevé à l'état passant et pouvant supporter une tension élevée à ses bornes à l'état bloqué.

Selon un aspect de l'invention, il est proposé un dispositif électronique intégré comportant :
- une diode Schottky comprenant une anode et une cathode mutuellement couplées par un gaz bidimensionnel d'électrons et ayant une première tension de seuil ;
- un composant de dérivation ayant une deuxième tension de seuil supérieure à la première tension de seuil et couplé en parallèle de la diode Schottky.

Selon l'invention, le composant de dérivation est un transistor à super-jonction latérale comportant une grille verticale isolée, une source connectée électriquement à l'anode de la diode Schottky et un drain connecté électriquement à la cathode de la diode Schottky, la grille verticale isolée et la source étant mutuellement électriquement couplées de façon à être au même potentiel électrique.

La combinaison d'une diode Schottky et d'un composant à super-jonction permet avantageusement, en l'absence de surcharge, une vitesse de commutation élevée, et en présence d'une surcharge, une faible résistivité à l'état passant permettant le passage d'un fort courant. En outre, le dispositif conserve une très bonne tenue en tension puisque la présence du composant de dérivation permet d'éviter d'avoir à abaisser la tenue en tension de la diode pour augmenter le courant à l'état passant.

Selon un mode de réalisation, le dispositif comporte une couche électriquement conductrice, la grille verticale isolée comportant une première portion verticale de la couche électriquement conductrice, ladite première portion étant isolée électriquement de la super-jonction par une couche diélectrique, la source du transistor comportant une deuxième portion de ladite couche électriquement conductrice.

La réalisation de la source et de la grille dans une même couche électriquement conductrice est avantageuse car elle rend le dispositif plus simple à fabriquer.

L'anode de la diode Schottky peut comporter la deuxième portion de la couche électriquement conductrice.

Ainsi, d'une part l'anode de la diode et la grille du transistor sont réalisées dans la même couche électriquement conductrice et d'autre part l'anode de la diode Schottky et la source du transistor sont confondues, ce qui rend le dispositif plus simple à fabriquer.

Le dispositif peut comporter une hétérojonction disposée sur la super-jonction et comportant une première couche de jonction et une deuxième couche de jonction, le gaz bidimensionnel d'électrons étant formé à l'interface entre la première couche de jonction et la deuxième couche de jonction.

Le gaz bidimensionnel d'électrons permet avantageusement une grande mobilité des porteurs de charge et contribue donc à augmenter la vitesse de commutation de la diode.

La deuxième portion de la couche électriquement conductrice peut former un contact Schottky avec le gaz bidimensionnel d'électrons, à distance des extrémités de la première couche de jonction.

Selon un mode de réalisation, le dispositif comprend au moins une plaque de champ comportant une portion horizontale de la couche électriquement conductrice.

La réalisation des plaques de champs par une portion de la couche électriquement conductrice est avantageuse car elle rend le dispositif plus simple à fabriquer.

Selon un mode de réalisation, le drain du transistor comporte une région semi-conductrice fortement dopée d'un premier type de conductivité, la super-jonction comportant un empilement vertical d'une alternance de couches semi-conductrices du premier type de conductivité et de couches semi-conductrices d'un deuxième type de conductivité opposé au premier type de conductivité, les premières et deuxièmes couches s'étendant horizontalement depuis la région semi-conductrice fortement dopée jusqu'à la grille verticale isolée.

Selon un mode de réalisation, la super-jonction comporte une alternance de cinq premières couches dopées de type N à une concentration de 4×10¹⁸ cm⁻³ et de cinq deuxièmes couches dopées de type P à une concentration de 4×10¹⁸ cm⁻³, les premières et deuxièmes couches ayant chacune une épaisseur égale à 150 nm.

Selon un mode de réalisation, la super-jonction est disposée sur une couche de tenue en tension d'épaisseur égale à 3 µm et dopée de type P à une concentration de 1×10¹⁶ cm⁻³.

La cathode de la diode Schottky peut comporter une couche électriquement conductrice en contact ohmique avec la région semi-conductrice fortement dopée et le gaz bidimensionnel d'électrons.

Selon un aspect de l'invention, il est proposé un procédé de fabrication d'un dispositif électronique intégré comportant les étapes suivantes :
- une formation d'une diode Schottky comportant une anode et une cathode mutuellement couplée par un gaz bidimensionnel d'électrons, la diode Schottky ayant une première tension de seuil ;
- une formation d'un composant de dérivation ayant une deuxième tension de seuil supérieure à la première tension de seuil ;
- un couplage parallèle du composant de dérivation et de la diode Schottky.

Selon l'invention, le composant de dérivation est un transistor à super-jonction latérale comportant une grille verticale isolée, un drain et une source, la grille verticale isolée et la source étant mutuellement électriquement couplées de façon à être au même potentiel électrique. La source est connectée électriquement à l'anode de la diode Schottky et le drain est connecté électriquement à la cathode de la diode Schottky.

Selon un mode de mise en œuvre, le procédé comporte :
- une réalisation de la super-jonction comprenant un empilement d'une alternance de premières couches semi-conductrices d'un premier type de conductivité et de deuxièmes couches semi-conductrices d'un deuxième type de conductivité opposé au premier type de conductivité,
- une réalisation d'une région semi-conductrice fortement dopée du premier type de conductivité à une première extrémité des couches semi-conductrices,
- une réalisation, sur la super-jonction, d'une hétérojonction comprenant une réalisation d'une première couche de jonction d'un premier matériau semi-conducteur et une réalisation d'une deuxième couche de jonction d'un deuxième matériau semi-conducteur sur la première couche de jonction, le premier et le deuxième matériau ayant des bandes interdites différentes de façon que le gaz bidimensionnel d'électrons se forme à l'interface entre la première couche de jonction et la deuxième couche de jonction,
- une réalisation d'une grille verticale isolée à une deuxième extrémité des couches semi-conductrices,
- une réalisation de l'anode de la diode Schottky par une formation d'un premier contact Schottky avec le gaz bidimensionnel d'électrons de façon que le premier contact Schottky et la grille verticale isolée soit mutuellement électriquement couplés,
- une réalisation d'un deuxième contact ohmique avec le gaz bidimensionnel d'électrons et la région semi-conductrice fortement dopée.

Le procédé peut comprendre un dépôt d'une couche électriquement conductrice de façon que la grille verticale isolée comporte une première portion de la couche électriquement conductrice et que le premier contact Schottky comprend une deuxième portion de la couche électriquement conductrice.

Le procédé peut comporter la réalisation d'au moins une plaque de champ comportant une troisième portion horizontale de la couche électriquement conductrice.

### BREVE DESCRIPTION DES FIGURES

Les dessins sont présentés à titre indicatif et nullement limitatif de l'invention.
La figure 1, décrite précédemment, illustre l'art antérieur.
Les figures 2 à 7 illustrent des modes réalisation et de mise en œuvre de l'invention.
Les figures 8 à 14 illustrent un procédé de fabrication d'un dispositif selon un mode de mise en œuvre de l'invention.

### DESCRIPTION DETAILLEE

[Fig. 2] La figure 2 est une représentation schématique d'un point de vue électrique d'un dispositif électronique intégré 1 selon un mode de réalisation de l'invention.

Le dispositif électronique 1 est ici un commutateur et peut trouver des applications dans toute sorte de système électronique de puissance, par exemple dans un abaisseur de tension ou dans un élévateur de tension.

Le dispositif électronique intégré 1 comporte une première borne B1, une deuxième borne B2, une diode 2 de type Schottky et un composant de dérivation 3, la diode 2 et le composant de dérivation 3 étant couplés en parallèle entre la première borne B1 et la deuxième borne B2. Le composant de dérivation est un transistor monté en diode, c'est à dire un transistor dont la grille et la source sont mutuellement électriquement couplées de façon à être au même potentiel électrique. La source du transistor 3 est connectée électriquement à l'anode de la diode Schottky 2 et le drain du transistor 3 est connecté électriquement à la cathode de la diode Schottky 2.

La diode 2 a une première tension de seuil, par exemple ici 0,3 volts, et le transistor 3 a ici une deuxième tension de seuil supérieure à la première tension de seuil, par exemple ici 1,5 volts.

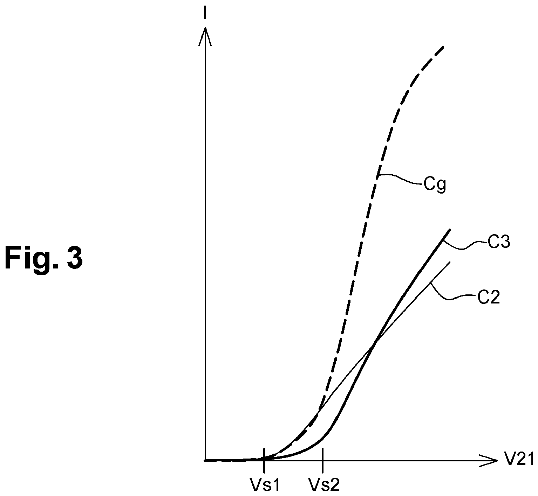

[Fig. 3] La figure 3 représente l'évolution des intensités des courants au sein du dispositif 1 en fonction de la valeur de la tension V21 entre la première borne B1 et la deuxième borne B2 du dispositif 1. L'intensité du courant I2 au travers de la diode 2 est représentée par la courbe référencée C2, l'intensité du courant I3 au travers du transistor 3 est représentée par la courbe référencée C3, et l'intensité du courant global Ig circulant entre la première borne B1 et la deuxième borne B2 est représentée par la courbe référencée Cg.

En fonctionnement, lorsque la valeur de la tension V21 est positive et inférieure à la première tension de seuil Vs1, le dispositif est bloqué et aucun courant ne le traverse.

Lorsque la valeur de la tension V21 est supérieure à la première tension de seuil Vs1 mais inférieure à la deuxième tension de seuil Vs2, la diode 2 est passante, le transistor 3 est bloqué et donc le dispositif 1 est passant et traversé par un courant qui traverse la diode 2. Ainsi, le courant global Ig traversant le dispositif est égal au courant I2 traversant la diode.

Lorsque la valeur de la tension V21 est supérieure à la deuxième tension de seuil Vs2, la diode 2 est passante, le transistor 3 est passant et le courant global Ig circule dans le dispositif 1 au travers de la diode 2 et du transistor 3. Le courant global Ig traversant le dispositif est égal à la somme du courant I2 et du courant I3.

Ainsi, pour des tensions élevées, le courant global Ig traversant le dispositif 1 n'est pas limité par la diode 2.

Lorsque la valeur de la tension V21 est négative, la diode et le transistor sont dans un état bloqué, et aucun courant ne traverse le dispositif 1.

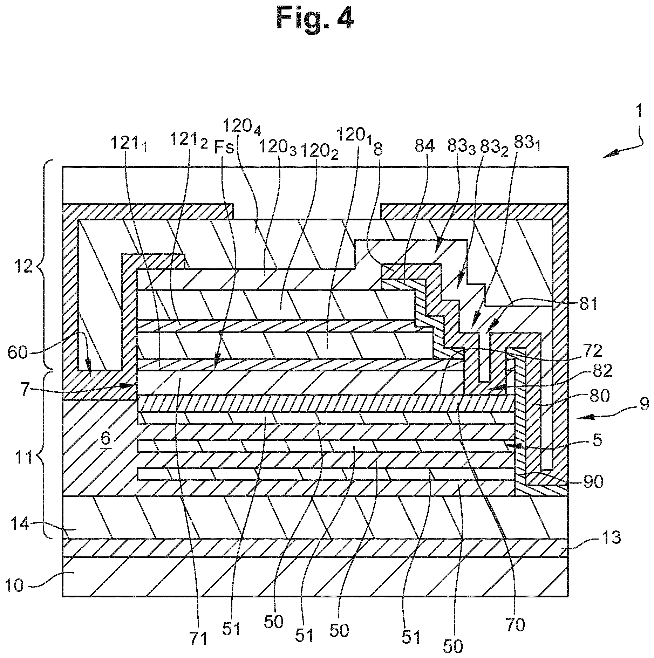

[Fig. 4] La figure 4 est une vue en coupe schématique du dispositif 1 selon un mode de réalisation de l'invention.

Le dispositif 1 comporte un substrat semi-conducteur 10 supportant une zone active 11, de préférence une zone active à base de nitrure de gallium. La zone active 11 comporte une face supérieure Fs, elle-même surmontée par une région d'interconnexion 12 dont seulement une partie est détaillée ici à des fins de simplification.

Le substrat 10 est ici un substrat en silicium intrinsèque. Il aurait toutefois été possible que le substrat soit un substrat en silicium dopé ou un substrat isolant. Le substrat aurait notamment pu être en carbure de silicium ou en saphir. Dans le cas d'une zone active 11 épitaxiée sur du silicium, l'épaisseur du substrat 10 est par exemple de 1 mm pour un diamètre de 200 mm. Le substrat 10 peut cependant avoir toute épaisseur comprise entre 400 µm et 2 mm (selon son diamètre).

Puisque le substrat 10 est en silicium et que la zone active 11 est à base de nitrure de gallium, la zone active 11 est avantageusement séparée du substrat 10 par une couche d'adaptation 13 formée par épitaxie.

La couche d'adaptation 13 sert d'intermédiaire entre le substrat 10 et la zone active 11 et permet une adaptation de maille entre le silicium du substrat 10 et le nitrure de gallium de la zone active 11. Elle permet également d'absorber les contraintes mécaniques entre le substrat 10 et la zone active 11. La couche d'adaptation 13 comporte classiquement une couche de nitrure d'aluminium.

Bien que la couche d'adaptation 13 soit réalisée ici sous la forme d'une seule couche, elle pourrait tout à fait comporter une pluralité de sous-couches d'adaptation empilées, et/ou être réalisée sur une sous-couche de nucléation, par exemple une couche de nitrure d'aluminium (AlN) en contact avec le substrat. Les sous-couches d'adaptation pourraient comprendre du nitrure d'aluminium-gallium, le taux d'aluminium pouvant varier d'une sous-couche d'adaptation à l'autre.

La couche d'adaptation 13 est par exemple composée d'un empilement d'AlN et d'AlGaN d'épaisseur 300 nm.

La région d'interconnexion 12 comporte classiquement une pluralité de vias et de pistes métalliques (non représentées à des fins de simplification), ainsi qu'une superposition de premières couches diélectriques 121_{1,} 121₂, par exemple en nitrure de silicium, et de deuxièmes couches diélectriques 120₁, 120₂, 120₃, 120₄, par exemple en orthosilicate de tétraéthyle (TEOS). Cette succession de couches diélectriques sert de support à la réalisation de plaque de champs dans la région d'interconnexion, comme il sera vu ci-après. La couche 120₃ sert aussi à encapsuler l'anode lors de la réalisation technologique de la cathode. La couche 120₄ sert aussi à encapsuler la cathode et constitue la couche diélectrique pour le premier niveau de via.

Le rôle des plaques de champ est de redistribuer le champ électrique dans le dispositif du fait des lignes équipotentielles qu'elles génèrent et d'éviter ainsi les pics de champ électrique, permettant ainsi une augmentation de la tension de claquage du dispositif 1.

La zone active 11 comporte une couche de tenue en tension 14 disposée sur la couche d'adaptation 13, une super-jonction 5 disposée sur la couche de tenue en tension 14 et une hétérojonction 7 disposée sur la super-jonction 5.

La couche de tenue en tension 14, de préférence en GaN dopé P, est dimensionnée pour tenir un champ électrique vertical qui advient lorsque le composant est en blocage. Elle peut être dopée à 1×10¹⁶ cm⁻³ et avoir une épaisseur de 3 µm pour un composant en blocage à 650 V (potentiel de l'anode = 0 V, potentiel de la cathode = potentiel du substrat= 650 V).

La super-jonction 5, réalisée ici directement sur la couche de tenue en tension 14, comporte un empilement vertical formé d'une pluralité de couches semi-conductrices, de préférence en nitrure de galium. L'empilement comporte une alternance de premières couches 50 dopées d'un premier type de conductivité, ici une conductivité de type N, et de deuxièmes couches 51 dopées d'un deuxième type de conductivité, ici une conductivité de type P.

Selon ce mode de réalisation, l'empilement comporte trois premières couches 50 semi-conductrices de type N et trois deuxièmes couches 51 semi-conductrices de type P.

L'alternance de couches semi-conductrices de conductivités différentes permet avantageusement, en cas de polarisation du dispositif avec une tension V21 négative, de générer des zones de déplétion aux jonctions P-N entre les différentes couches de l'empilement.

Les premières et deuxièmes couches 50 et 51 sont avantageusement empilées de façon que la première couche de l'empilement, c'est-à-dire la couche inférieure en contact avec la couche de tenue en tension 14 (dopée de type P) soit une couche de type N, et la dernière couche de l'empilement, c'est-à-dire la couche supérieure la plus éloignée du substrat 10 et sur laquelle est réalisée l'hétérojonction 7, soit une couche de type P.

L'ordre choisi pour les premières et deuxièmes couches 50 et 51 est avantageux car il assure que l'ensemble des premières couches ou canaux de type N 50 soient entourées par des zones de type P. Ces zones de type P favorisent une déplétion des canaux 50 en blocage, empêchant ainsi la circulation d'électrons dans ces canaux.

Le rapport entre l'épaisseur des couches semi-conductrices 50 et 51 et la hauteur des zones de déplétion peut être adapté en faisant varier la hauteur des couches et/ou le dopage des premières et deuxièmes couches semi-conductrices 50 et 51.

Par exemple ici, les hauteurs des zones de déplétion sont égales à l'épaisseur des couches correspondantes ; le dopage des premières couches 50 est de 4×10¹⁸ cm⁻³ et le dopage des deuxièmes couches 51 est de 4×10 ¹⁸cm⁻³ pour une épaisseur des premières couches et des deuxièmes couches de 150 nm.

Ainsi, en cas d'application d'une tension V21 négative, les premières couches 50 et les deuxièmes couches 51 sont complètement déplétées. Cela permet avantageusement une très bonne tenue en tension. Ici, le dispositif 1 supporte une tension V21 entre la première borne B1 et la deuxième borne B2 égale à 650 V (lorsque la couche 14 mesure 3 µm d'épaisseur).

Il serait toutefois possible de choisir tout autre valeur de dopage et/ou tout autre valeur d'épaisseur des premières couches 50 et des deuxièmes couches 51. L'homme du métier saura choisir les paramètres adaptés en fonction des applications envisagées.

La super-jonction 5 comporte en outre une région semi-conductrice fortement dopée 6 du premier type de conductivité réalisée au niveau d'une première extrémité latérale de l'empilement et qui s'étend dans la zone active le long de l'empilement de façon à être en contact avec les premières et deuxièmes couches 50 et 51 de l'empilement. En raison de la nature de son dopage, ici un dopage de type N, la région semi-conductrice fortement dopée 6 forme une continuité électrique avec les premières couches 50 de type N.

L'hétérojonction 7 est réalisée directement sur la super-jonction 5 et comporte ici deux couches semi-conductrices 70, 71 superposées, dites couches de jonction.

Une première couche de jonction 70 est réalisée directement sur l'empilement 5, c'est-à-dire ici directement sur la deuxième couche semi-conductrice 51 de type P supérieure, et comporte un premier matériau semi-conducteur, par exemple du nitrure de gallium non intentionnellement dopé. La première couche de jonction 70 est en contact avec la région semi-conductrice fortement dopée 6.

Une deuxième couche de jonction 71 est réalisée directement sur la première couche de jonction 70 et comporte un deuxième matériau semi-conducteur intrinsèque ou faiblement dopée de type N (par exemple de l'ordre de 2×10¹⁶ cm⁻³), ici du nitrure d'aluminium-gallium. La deuxième couche de jonction 71 comporte la face supérieure Fs de la zone active 11.

La superposition d'une couche de nitrure de galium et d'une couche de nitrure d'aluminium-galium est particulièrement avantageuse ici puisqu'en raison de la différence de taille des bandes interdites de ces deux matériaux, un gaz bidimensionnel d'électrons 72 se forme à l'interface entre la première couche de jonction 70 et la deuxième couche de jonction 71.

Le dispositif 1 comporte en outre une couche électriquement conductrice 8, ici une couche métallique, qui s'étend partiellement dans la zone active 11 et partiellement dans la région d'interconnexion 12, et en particulier dans différents niveaux de la région d'interconnexion 12.

Le dispositif 1 comporte une grille verticale isolée 9 qui s'étend le long de l'empilement de la super-jonction 5 depuis la région d'interconnexion 12.

La grille verticale 9 comporte une couche verticale isolante 90 d'un matériau diélectrique (par exemple SiO₂, Al₂O₃, Si₃N₄, SiN), autrement appelé diélectrique de grille, directement en contact avec les premières et deuxièmes couches 50 et 51, et une couche de matériau de grille, formée ici par une première portion verticale 80 de la couche électriquement conductrice 8.

La couche électriquement conductrice 8 comporte une deuxième portion 81, par exemple en forme de U, s'étendant verticalement depuis la région d'interconnexion 12 jusqu'à venir contacter horizontalement, c'est-à-dire par la base du U, la première couche de jonction 70 à distance des extrémités de la première couche de jonction 70 de façon à former un premier contact 82 de type Schottky avec le gaz bidimensionnel d'électrons 72.

Dans ce mode de réalisation, le premier contact Schottky 82 est situé à une première distance de la région semi-conductrice fortement dopée 6 et à une deuxième distance de la grille verticale isolée 9, la première distance étant nettement supérieure à la deuxième distance, par exemple ici vingt fois supérieure. La distance entre le premier contact Schottky 82 et le diélectrique de grille 90 peut être minimisée afin d'avoir la plus faible résistance possible entre ce contact et le canal formé sous la grille.

La couche électriquement conductrice 8 comporte en outre une troisième portion 83 s'étendant dans la région d'interconnexion 12, et plus particulièrement sur plusieurs niveaux de la région d'interconnexion 12 de façon à épouser le profil de la superposition des couches de nitrure de silicium 121 et des couches d'orthosilicate de tétraéthyle 120.

Ici, la troisième portion 83 de la couche électriquement conductrice 8 est séparée des couches 120 et 121 par une couche de matériau diélectrique 84.

Les trois sous-portion horizontales 83₁, 83₂ et 83₃ ainsi formées par la troisième portion 83 de la couche électriquement conductrice 8 forment ici des plaques de champs pour le dispositif 1.

Le dispositif 1 comporte en outre un deuxième contact 60 de type ohmique réalisé dans la région semi-conductrice fortement dopée 6 de façon à être en contact avec la première couche de jonction 70. Ce deuxième contact ohmique 60 établi une connexion électrique avec le gaz bidimensionnel d'électrons 72, avec la région semi-conductrice fortement dopée 6 et avec les premières couches 50.

Le premier contact 82 de type Schottky est ici couplé à la deuxième borne B2 et le deuxième contact ohmique 60 est ici couplé à la première borne B1.

La diode 2 est ici une diode de type Schottky dont l'anode comporte le premier contact Schottky 82 et dont la cathode comporte le deuxième contact ohmique 60, l'anode et la cathode étant couplées par la portion du gaz bidimensionnel d'électrons 72 située entre la région semi-conductrice fortement dopée 6 et le premier contact Schottky 82. La présence du gaz bidimensionnel d'électrons 72 permet une grande mobilité des électrons dans la première couche de jonction 70 et donc une faible résistance à l'état passant de la diode.

Le transistor 3 comporte ici une région de drain formée par la région semi-conductrice fortement dopée 6 et une région de source formée par la deuxième portion 81 de la couche électriquement conductrice 8, et en particulier par le premier contact Schottky 82. La grille du transistor 3 comporte la grille verticale isolée 9.

Ainsi, le premier contact Schottky 82 est ici un contact double puisqu'il forme un contact pour l'anode de la diode 2 et pour la source du transistor 3.

Puisque le matériau de grille est formé par la première portion verticale 80 de la couche électriquement conductrice 8 et puisque la source est formée par la deuxième portion 81 de la couche électriquement conductrice 8, la source et la grille du transistor 3 sont mutuellement électriquement couplées de façon à être au même potentiel électrique et le transistor 3 est donc monté en diode.

Ainsi en fonctionnement lorsque la tension V21 entre la première borne B1 et la deuxième borne B2, c'est-à-dire entre le premier contact Schottky 82 et le deuxième contact ohmique 60, est négative, alors la diode 2 et le transistor 3 sont bloqués, et en particulier les premières couches 50 et les deuxièmes couches 51 sont complètement déplétées. Aucun courant ne circule entre la première borne B1 et la deuxième borne B2.

Lorsque la tension V21 entre la première borne B1 et la deuxième borne B2 est positive mais inférieure à la première tension de seuil, c'est-à-dire au seuil de conduction de la diode, la diode 2 et le transistor 3 sont bloqués, et en particulier la polarisation de la grille verticale 9 est insuffisante pour la création d'une zone d'inversion dans les deuxièmes couches semi-conductrices 51. Aucun courant ne circule entre la première borne B1 et la deuxième borne B2.

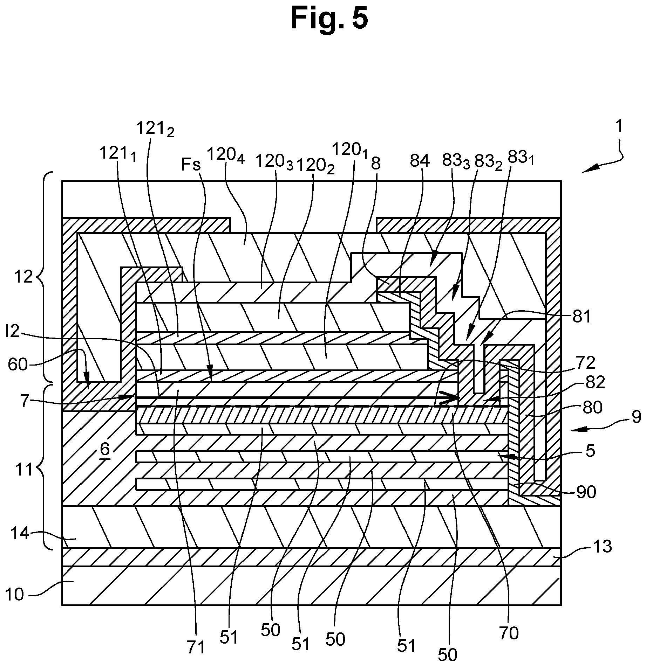

[Fig. 5] Comme l'illustre la figure 5, lorsque la tension V21 est supérieure à la première tension de seuil Vs1 et inférieure à la deuxième tension de seuil Vs2, c'est-à-dire inférieure au seuil de conduction du transistor 3, alors la diode 2 devient passante et le courant I2 circule entre la première borne et la deuxième borne via le gaz bidimensionnel d'électrons 72. Puisque la tension V21 est inférieure à la tension de seuil du transistor, la polarisation de la grille 9 est insuffisante pour la création d'une zone d'inversion dans les deuxièmes couches semi-conductrices 51. Le transistor est donc bloqué

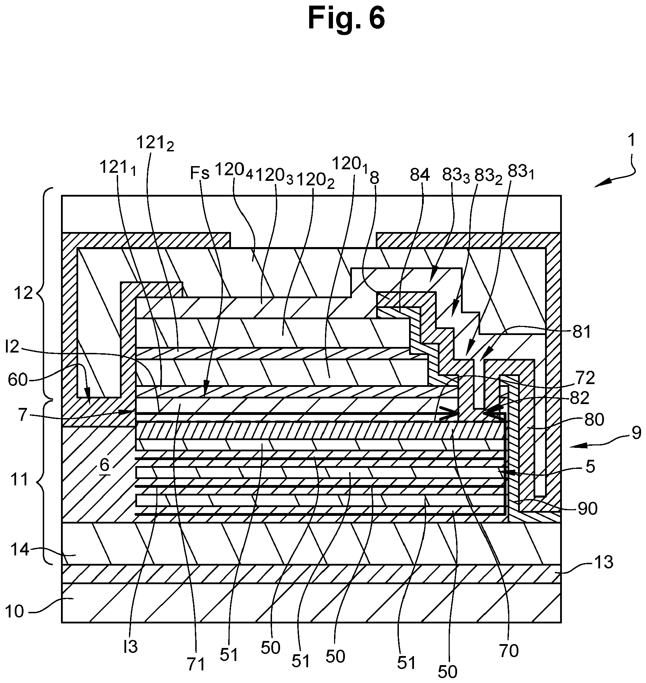

[Fig. 6] Comme l'illustre la figure 6, lorsque la tension V21 est supérieure à la deuxième tension de seuil Vs2, c'est-à-dire lorsqu'une surcharge apparait entre la première borne et la deuxième borne, alors la diode 2 et le transistor 3 sont passants. En particulier, une zone d'inversion est créée dans les deuxième couches semi-conductrices 51 le long de la grille verticale 9 et le courant I3 circule entre la première borne B1 et la deuxième borne B2 le long des premières couches semi-conductrices 50, le long de la grille verticale isolée 9 au travers du canal formé par les zones d'inversion dans les deuxièmes couches semi-conductrices 51, et dans la portion du gaz bidimensionnel d'électrons 72 située entre la grille verticale 9 et le premier contact Schottky 82.

Ainsi le dispositif 1 permet une circulation d'un courant élevée entre ses bornes en faisant circuler ladite surcharge au travers du transistor 3

Bien qu'il ait été décrit un dispositif électronique intégré dans lequel la super-jonction comporte trois premières couches semi-conductrices de type N, il serait tout à fait possible que la super-jonction comporte un nombre de première couches semi-conductrices différent, préférentiellement compris entre 1 et 10.

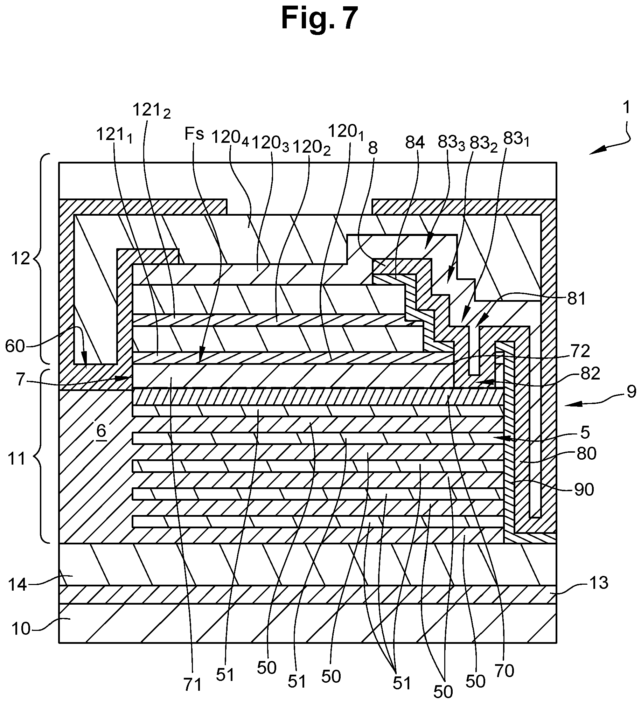

[Fig. 7] Ainsi, comme l'illustre la figure 7, le dispositif 1 peut comprendre une super-jonction comportant 5 premières couches semi-conductrices 50 et 5 deuxièmes couches semi-conductrices 51.

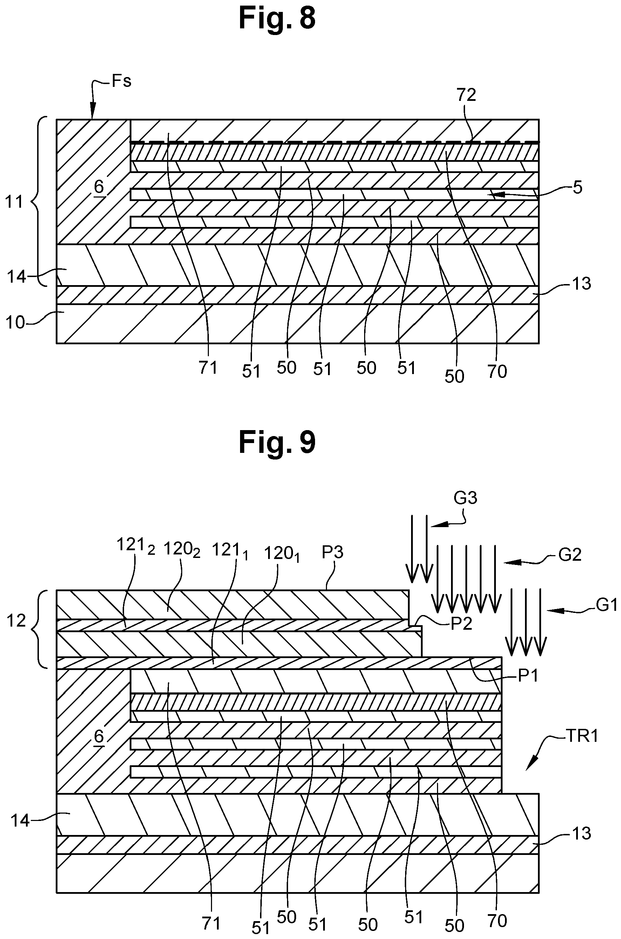

Les figure 8 à 14 illustrent différentes étapes d'un procédé de fabrication d'un dispositif 1 selon l'invention.

[Fig. 8] Selon une première étape du procédé de fabrication illustré par la figure 8, on réalise la zone active 11 sur le substrat semi-conducteur 10 et la couche d'adaptation 13.

La réalisation de la zone active 11 comporte une réalisation de la couche de tenue en tension 14 sur la couche d'adaptation 13 et une réalisation de la super-jonction 5 sur la couche de tenue en tension 14, par réalisation successive des premières couches semi-conductrices 50 et des deuxième couches semi-conductrice 51. La couche de tenue en tension 14, les première couches semi-conductrices 50 et les deuxièmes couches semi-conductrices 51 sont ici réalisées par épitaxie de nitrure de galium.

La réalisation de la super-jonction 5 comporte en outre la réalisation de la région semi-conductrice fortement dopée 6. La réalisation de la région 6 peut comporter une implantation à forte énergie de dopants de type N directement dans les premières couches semi-conductrice 50 et dans les deuxième couches semi-conductrice 51, au niveau d'une extrémité de l'empilement des premières et deuxièmes couches semi-conductrices 50 et 51.

En variante, il aurait été possible de réaliser la région semi-conductrice fortement dopée 6 par réalisation d'une tranchée dans l'empilement des premières et deuxième couches semi-conductrices 50 et 51 puis par remplissage de la tranchée par un matériau semi-conducteur de type N, par exemple du nitrure de gallium.

La réalisation de la zone active 11 comporte en outre la réalisation de l'hétérojonction 7 sur la super-jonction 5. La réalisation de l'hétérojonction 7 comprend une réalisation de la première couche de jonction 70, ici par dépôt d'une couche de nitrure de gallium non intentionnellement dopée directement sur la super-jonction 5, et une réalisation de la deuxième couche de jonction 71, ici par dépôt d'une couche de nitrure d'aluminium-gallium directement sur la première couche de jonction 70.

Une fois l'hétérojonction 7 réalisée, le gaz bidimensionnel d'électrons 72 se forme à l'interface entre la première couche de jonction 70 et la deuxième couche de jonction 71.

[Fig. 9] Comme l'illustre la figure 9, le procédé comporte la réalisation, dans la région d'interconnexion 12, ici directement sur la deuxième couche de jonction 71, d'un empilement d'une première couche de nitrure de silicium 121₁, d'une première couche de TEOS 120₁, d'une deuxième couche de nitrure de silicium 121₂ et d'une deuxième couche de TEOS 120₂, suivi de trois gravures successives G1, G2 et G3 de façon à définir un profil de support pour le dépôt ultérieur de la couche électriquement conductrice 8.

Une première gravure G1 est ici réalisée au travers des couches de nitrure de silicium 121₁ et 121₂, des couches de TEOS 120₁ et 120₂, et des premières et deuxièmes couches 51 et 52 de la super-jonction 5 jusqu'à la couche de tenue en tension 14 de façon à former une première tranchée TR1.

Une deuxième gravure G2 est réalisée au travers de la deuxième couche de TEOS 120₂, de la deuxième couche de nitrure de silicium 121₂ et de la première couche de TEOS 120₁ jusqu'à la première couche de nitrure de silicium 121₁ de façon à définir un premier palier P1 dans la région d'interconnexion 12.

Une troisième gravure G3 est réalisée au travers de la deuxième couche de TEOS 120₂, et au travers d'une partie de la deuxième couche de nitrure de silicium 121₂ de façon à définir un deuxième palier P2 et un troisième palier P3 dans la partie d'interconnexion 12.

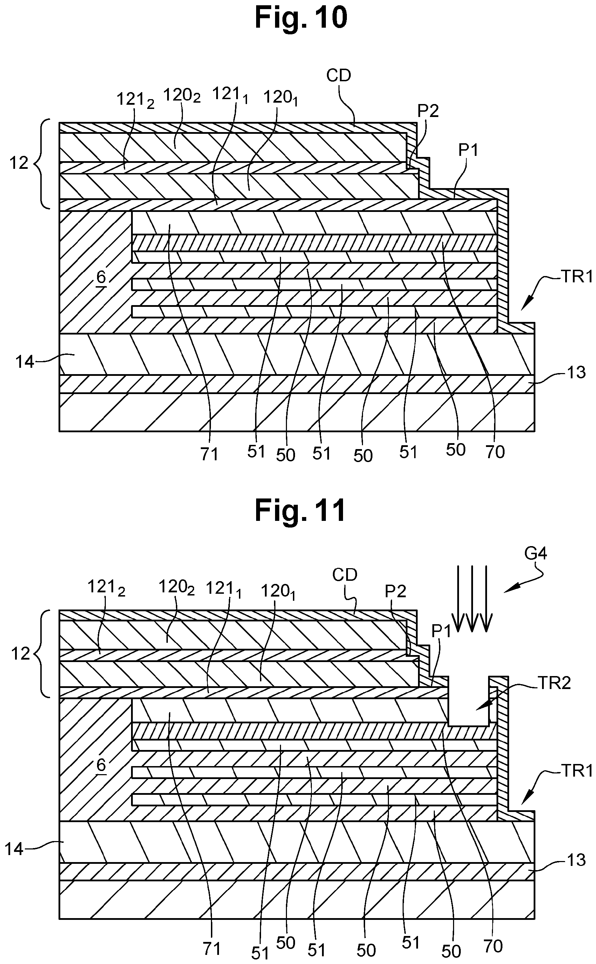

[Fig. 10] La figure 10 illustre une étape ultérieure du procédé de fabrication comportant un dépôt d'une couche de matériau diélectrique CD de façon à recouvrir le premier palier P1, le deuxième palier P2, le troisième palier P3 ainsi que le fond et la paroi latérale de la première tranchée TR1.

[Fig. 11] Puis, comme l'illustre la figure 11, une quatrième gravure G4 est réalisée sur une portion du premier palier P1, de façon à réaliser une deuxième tranchée TR2 s'étendant au travers de la couche diélectrique CD jusque dans la première couche de jonction 70, au travers de la première couche de nitrure de silicium 121₁ et de la deuxième couche de jonction 71. La première couche de jonction 70 peut être en partie gravée, comme cela est illustré par la figure 11, afin de former ultérieurement un contact latéral avec le gaz bidimensionnel d'électrons, ou la gravure peut s'arrêter sur la face supérieure de la première couche de jonction 70 pour former ultérieurement un contact planaire avec le gaz bidimensionnel d'électrons, tel qu'illustré par les figures 4 à 7.

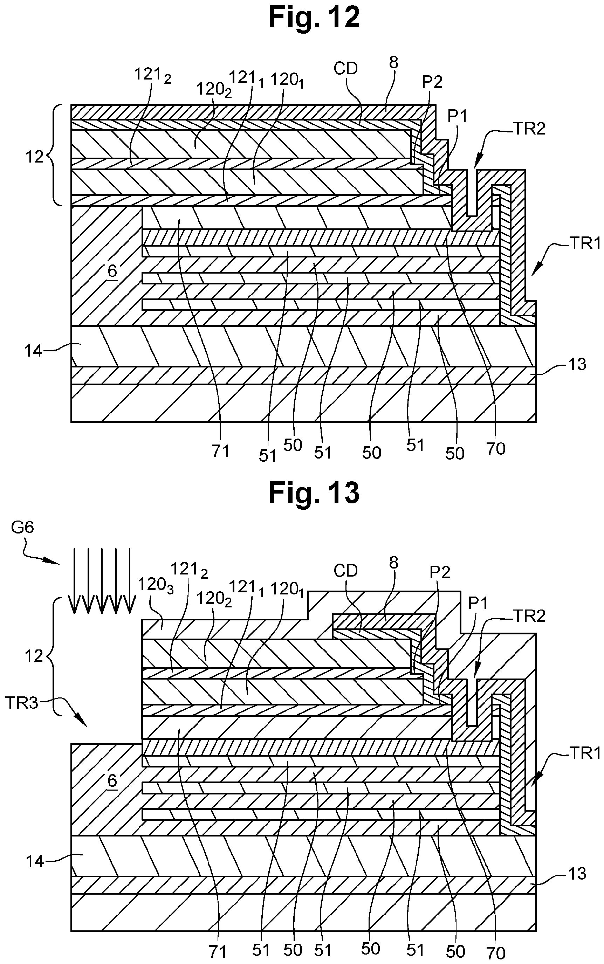

[Fig. 12] La couche électriquement conductrice 8 est ensuite déposée (figure 12) de façon que la première portion 80 recouvre la paroi latérale de la première tranchée, que la deuxième portion 81 en forme de U recouvre la paroi latérale de la deuxième tranchée TR2 formant ainsi le premier contact Schottky 82, et que les sous-portions horizontales 83₁, 83₂, 83₃, recouvrent respectivement le premier palier P1, le deuxième palier P2 et le troisième palier P3.

[Fig. 13] Lors d'une étape ultérieure (figure 13) du procédé de fabrication, on réalise une cinquième gravure (non représentée) d'une portion de la couche diélectrique CD et de la couche électriquement conductrice 8, puis on réalise un dépôt d'une troisième couche de matériau diélectrique, ici la troisième couche de TEOS 120₃, et on effectue une sixième gravure G6 de la région d'interconnexion 12 et d'une partie de la région semi-conductrice fortement dopée 6 de façon à former une troisième tranchée TR3 qui découvre la région semi-conductrice fortement dopée 6 et la première couche de jonction 70.

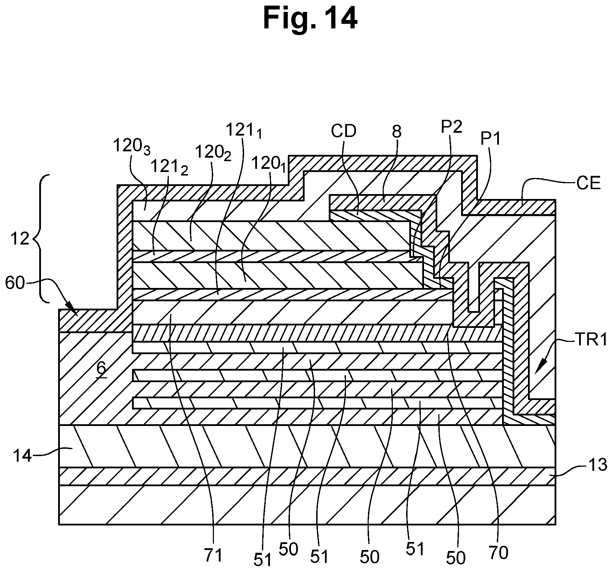

[Fig. 14] On dépose ensuite (figure 14) une deuxième couche électriquement conductrice CE, ici une couche métallique, de façon à recouvrir notamment le fond de la troisième tranchée TR3 et former ainsi le deuxième contact ohmique 60.

Le procédé de fabrication est ensuite achevé de façon à obtenir le dispositif illustré par la figure 4 et décrit précédemment, par la gravure d'une portion de la deuxième couche électriquement conductrice CE (délimitation de la cathode), le dépôt d'une couche de matériau diélectrique, ici la quatrième couche de TEOS 120₄, et par la réalisation de deux portions disjointes d'une troisième couche électriquement conductrice permettant d'établir une connexion électrique entre le premier contact Schottky 82 et la région d'interconnexion 12 et entre le deuxième contact ohmique 60 et la région d'interconnexion 12.

## Revendications

1. Dispositif électronique intégré comportant :
- une diode Schottky (2) comprenant une anode et une cathode mutuellement couplées par un gaz bidimensionnel d'électrons (72) et ayant une première tension de seuil (Vs1),
- un composant de dérivation (3) ayant une deuxième tension de seuil (Vs2) supérieure à la première tension de seuil (Vs1) et couplé en parallèle de la diode Schottky,
le dispositif étant **caractérisé en ce que** le composant de dérivation (3) est un transistor à super-jonction latérale comportant une grille verticale isolée (9), une source connectée électriquement à l'anode de la diode Schottky (2) et un drain connecté électriquement à la cathode de la diode Schottky (2), la grille verticale isolée (9) et la source étant mutuellement électriquement couplées de façon à être au même potentiel électrique.

2. Dispositif selon la revendication 1, comportant une couche électriquement conductrice (8), la grille verticale isolée (9) comportant une première portion (80) verticale de la couche électriquement conductrice (8), ladite première portion (80) étant isolée électriquement de la super-jonction (5) par une couche diélectrique (90), la source du transistor (3) comportant une deuxième portion (81) de ladite couche électriquement conductrice (8).

3. Dispositif selon la revendication 2, dans lequel l'anode de la diode Schottky (2) comporte la deuxième portion (81) de la couche électriquement conductrice (8).

4. Dispositif selon l'une des revendications 2 et 3, dans lequel le dispositif comporte une hétérojonction (7) disposée sur la super-jonction (5) et comportant une première couche de jonction (70) et une deuxième couche de jonction (71), le gaz bidimensionnel d'électrons (72) étant formé à l'interface entre la première couche de jonction (70) et la deuxième couche de jonction (71).

5. Dispositif selon la revendication 4, dans lequel la deuxième portion (81) de la couche électriquement conductrice (8) forme un contact Schottky (82) avec le gaz bidimensionnel d'électrons (72), à distance des extrémités de la première couche de jonction (70).

6. Dispositif selon l'une quelconque des revendications 2 à 5, comprenant au moins une plaque de champ comportant une portion horizontale (83₁) de la couche électriquement conductrice (8).

7. Dispositif selon l'une quelconque des revendication 1 à 6, dans lequel :
- le drain du transistor (3) comporte une région semi-conductrice fortement dopée (6) d'un premier type de conductivité ;
- la super-jonction (5) comporte un empilement vertical d'une alternance de couches semi-conductrices du premier type de conductivité (50) et de couches semi-conductrices d'un deuxième type de conductivité (51) opposé au premier type de conductivité ; et
- les premières et deuxièmes couches (50, 51) s'étendent horizontalement depuis la région semi-conductrice fortement dopée (6) jusqu'à la grille verticale isolée (9).

8. Dispositif selon la revendication 7, dans lequel la super-jonction (5) comporte une alternance de cinq premières couches (50) dopées de type N à une concentration de 4×10¹⁸ cm⁻³ et de cinq deuxièmes couches (51) dopées de type P à une concentration de 4×10¹⁸ cm⁻³, les premières et deuxièmes couches (50, 51) ayant chacune une épaisseur égale à 150 nm.

9. Dispositif selon la revendication 8, dans lequel la super-jonction (5) est disposée sur une couche de tenue en tension (14) d'épaisseur égale à 3 µm et dopée de type N à une concentration de 1×10¹⁶ cm⁻³.

10. Dispositif selon l'une des revendications 7 à 9, dans lequel la cathode de la diode Schottky (2) comporte une couche électriquement conductrice (CE) en contact ohmique avec la région semi-conductrice fortement dopée (6) et le gaz bidimensionnel d'électrons (72).

11. Procédé de fabrication d'un dispositif électronique intégré comportant les étapes suivantes :
- une formation d'une diode Schottky (2) comportant une anode et une cathode mutuellement couplées par un gaz bidimensionnel d'électrons (72), la diode Schottky (2) ayant une première tension de seuil (Vs1) ;
- une formation d'un composant de dérivation (3) ayant une deuxième tension de seuil (Vs2) supérieure à la première tension de seuil (Vs1), le composant de dérivation (3) étant un transistor à super-jonction latérale comportant une grille verticale isolée (9), une source et un drain, la grille verticale isolée (9) et la source étant mutuellement électriquement couplées de façon à être au même potentiel électrique ;
- un couplage parallèle du composant de dérivation (3) et de la diode Schottky (2), la source du transistor étant connectée électriquement à l'anode de la diode Schottky (2) et le drain du transistor étant connecté électriquement à la cathode de la diode Schottky (2).

12. Procédé selon la revendication 11, comportant :
- une réalisation de la super-jonction comprenant un empilement d'une alternance de première couches semi-conductrices (50) d'un premier type de conductivité et de deuxièmes couches semi-conductrices (51) d'un deuxième type de conductivité opposé au premier type de conductivité,
- une réalisation d'une région semi-conductrice fortement dopée (6) du premier type de conductivité à une première extrémité des couches semi-conductrices,
- une réalisation, sur la super-jonction, d'une hétérojonction comprenant une réalisation d'une première couche de jonction (70) d'un premier matériau semi-conducteur et une réalisation d'une deuxième couche de jonction (71) d'un deuxième matériau semi-conducteur sur la première couche de jonction (70), le premier et le deuxième matériau ayant des bandes interdites différentes de façon que le gaz bidimensionnel d'électrons (72) se forme à l'interface entre la première couche de jonction (70) et la deuxième couche de jonction (71),
- une réalisation d'une grille verticale isolée (9) à une deuxième extrémité des couches semi-conductrices (50, 51),
- une réalisation de l'anode de la diode Schottky (2) par une formation d'un premier contact Schottky (82) avec le gaz bidimensionnel d'électrons (72) de façon que le premier contact Schottky (82) et la grille verticale isolée (9) soit mutuellement électriquement couplés,
- une réalisation d'un deuxième contact ohmique (60) avec le gaz bidimensionnel d'électrons (72) et la région semi-conductrice fortement dopée (6).

13. Procédé selon la revendication 12, comprenant un dépôt d'une couche électriquement conductrice (8), de façon que la grille verticale isolée (9) comporte une première portion (80) de la couche électriquement conductrice (8) et que le premier contact Schottky (82) comprend une deuxième portion (81) de la couche électriquement conductrice (8).

14. Procédé selon la revendication 13, comprenant la réalisation d'au moins une plaque de champ comportant une troisième portion horizontale (83₁) de la couche électriquement conductrice (8).

## Patentansprüche

1. Eingebaute elektronische Vorrichtung, umfassend:
- eine Schottky-Diode (2), umfassend eine Anode und eine Kathode, die aneinander durch ein zweidimensionales Elektronengas (72) gekoppelt sind und eine erste Grenzspannung (Vs1) aufweisen;
- ein Ableitbauteil (3) mit einer zweiten Grenzspannung (Vs2), die höher ist als die erste Grenzspannung (Vs1) und parallel zur Schottky-Diode gekoppelt ist;
wobei die Vorrichtung **dadurch gekennzeichnet ist, dass** das Ableitbauteil (3) ein Transistor mit seitlicher Super-Verbindungsnahtstelle ist, die ein isoliertes vertikales Gitter (9), eine elektrisch an die Anode der Schottky-Diode (2) angeschlossene Source und ein elektrisch an die Kathode der Schottky-Diode (2) angeschlossenes Drain umfasst, wobei das isolierte vertikale Gitter (9) und die Source elektrisch derart aneinander gekoppelt sind, dass sie dasselbe elektrische Potenzial aufweisen.

2. Vorrichtung gemäß Anspruch 1, umfassend eine elektrisch leitende Schicht (8), wobei das isolierte vertikale Gitter (9) einen ersten vertikalen Abschnitt (80) der elektrisch leitenden Schicht (8) umfasst, wobei der genannte erste Abschnitt (80) elektrisch von der Super-Verbindungsnahtstelle (5) durch eine dielektrische Schicht (90) isoliert ist, wobei die Source des Transistors (3) einen zweiten Abschnitt (81) der genannten elektrisch leitenden Schicht (8) umfasst.

3. Vorrichtung gemäß Anspruch 2, bei der die Anode der Schottky-Diode (2) den zweiten Abschnitt (81) der elektrisch leitenden Schicht (8) umfasst.

4. Vorrichtung gemäß einem der Ansprüche 2 und 3, bei der die Vorrichtung eine Hetero-Verbindungsnahtstelle (7) umfasst, die auf der Super-Verbindungsnahtstelle (5) angeordnet ist und eine erste Verbindungsschicht (70) und eine zweite Verbindungsschicht (71) umfasst, wobei das zweidimensionale Elektronengas (72) an der Schnittstelle zwischen der ersten Verbindungsschicht (70) und der zweiten Verbindungsschicht (71) gebildet ist.

5. Vorrichtung gemäß Anspruch 4, bei der der zweite Abschnitt (81) der elektrisch leitenden Schicht (8) mit dem zweidimensionalen Elektronengas (72) von den Enden der ersten Verbindungsschicht (70) entfernt einen Schottky-Kontakt (82) bildet.

6. Vorrichtung gemäß irgendeinem der Ansprüche 2 bis 5, umfassend wenigstens eine Feldplatte, umfassend einen horizontalen Abschnitt (83₁) der elektrisch leitenden Schicht (8).

7. Vorrichtung gemäß irgendeinem der Ansprüche 1 bis 6, bei der:
- das Drain des Transistors (3) eine Halbleiter-Region umfasst, die stark mit einem ersten Leitungstyp gedopt ist (6);
- die Super-Verbindungsnahtstelle (5) eine vertikale Stapelung eines Wechsels von Halbleiter-Schichten vom ersten Leitfähigkeitstyp (50) und aus Halbleiter-Schichten eines zweiten Leitfähigkeitstyps (51) umfasst, der dem ersten Leitfähigkeitstyp entgegengesetzt ist; und
- die ersten und die zweiten Schichten (50, 51) sich horizontal von der stark gedopten Halbleiterschicht (6) bis zum isolierten vertikalen Gitter (9) erstrecken.

8. Vorrichtung gemäß Anspruch 7, bei der die Super-Verbindungsnahtstelle (5) einen Wechsel von fünf ersten gedopten Schichten (50) vom Typ N in einer Konzentration von 4 × 10¹⁸ cm⁻³ und fünf zweiten gedopten Schichten (51) vom Typ P in einer Konzentration von 4 × 10¹⁸ cm⁻³ umfasst, wobei die ersten und die zweiten Schichten (50, 51) jeweils eine Dicke von gleich 50 nm aufweisen.

9. Vorrichtung gemäß Anspruch 8, bei der die Super-Verbindungsnahtstelle (5) auf einer spannungsfesten Schicht (14) mit einer Dicke gleich 3 µm und die vom Typ N in einer Konzentration von 1 × 10¹⁶ cm⁻³ gedopt ist, angeordnet ist.

10. Vorrichtung gemäß einem der Ansprüche 7 bis 9, bei der die Kathode der Schottky-Diode (2) eine elektrisch leitende Schicht (CE) umfasst, die mit der stark gedopten Halbleiter-Region (6) und dem zweidimensionalen Elektronengas (72) in Kontakt ist.

11. Herstellungsverfahren einer eingebauten elektronischen Vorrichtung, umfassend die folgenden Schritte:
- eine Bildung einer Schottky-Diode (2), umfassend eine Anode und eine Kathode, die aneinander durch ein zweidimensionales Elektronengas (72) gekoppelt werden, wobei die Schottky-Diode (2) eine erste Grenzspannung (Vs1) aufweist;
- eine Bildung eines Ableitungsbauteils (3) mit einer zweiten Grenzspannung (Vs2), die größer ist als die erste Grenzspannung (Vs1), wobei das Ableitungsbauteil (3) ein Transistor mit seitlicher Super-Verbindungsnahtstelle ist, die ein isoliertes vertikales Gitter (9), eine Source und ein Drain umfasst, wobei das isolierte vertikale Gitter (9) und die Source elektrisch derart aneinander gekoppelt sind, dass sie dasselbe elektrische Potenzial aufweisen;
- eine parallele Kopplung des Ableitungsbauteils (3) und der Schottky-Diode (2), wobei die Source des Transistors elektrisch an die Anode der Schottky-Diode (2) angeschlossen wird und das Drain des Transistors elektrisch an die Kathode der Schottky-Diode (2) angeschlossen wird.

12. Verfahren gemäß Anspruch 11, umfassend:
- eine Ausführung der Super-Verbindungsnahtstelle, umfassend eine Stapelung eines Wechsels von ersten Halbleiter-Schichten (50) eines ersten Leitfähigkeitstyps und von zweiten Halbleiterschichten (51) eines zweiten Leitfähigkeitstyps, der dem ersten Leitfähigkeitstyp entgegengesetzt ist,
- eine Ausführung einer stark gedopten Halbleiter-Region (6) vom ersten Leitfähigkeitstyp an einem ersten Ende der Halbleiter-Schichten,
- eine Ausführung auf einer Hetero-Verbindungsnahtstelle auf der Super-Verbindungsnahtstelle, umfassend eine Ausführung einer ersten Verbindungsschicht (70) eines ersten Halbleitermaterials und eine Ausführung einer zweiten Verbindungsschicht (71) eines zweiten Halbleitermaterials auf der ersten Verbindungsschicht (70), wobei das erste und das zweite Material derart unterschiedliche verbotene Bänder aufweisen, dass das zweidimensionale Elektronengas (72) sich in der Schnittstelle zwischen der ersten Verbindungsschicht (70) und der zweiten Verbindungsschicht (71) bildet,
- eine Ausführung eines isolierten vertikalen Gitters (9) an einem zweiten Ende der Halbleiter-Schichten (50, 51),
- eine Ausführung der Anode der Schottky-Diode (2) durch eine Bildung eines ersten Schottky-Kontaktes (82) mit dem zweidimensionalen Elektronengas (72) derart, dass der erste Schottky-Kontakt (82) und das isolierte vertikale Gitter (9) elektrisch aneinander gekoppelt werden,
- eine Ausführung eines zweiten ohmschen Kontakts (60) mit dem zweidimensionalen Elektronengas (72) und der stark gedopten (6) Halbleiter-Region.

13. Verfahren gemäß Anspruch 12, umfassend ein Aufbringen einer elektrisch leitenden Schicht (8) derart, dass das isolierte vertikale Gitter (9) einen ersten Abschnitt (80) der elektrisch leitenden Schicht (8) umfasst und dass der erste Schottky-Kontakt (82) einen zweiten Abschnitt (81) der elektrisch leitenden Schicht (8) umfasst.

14. Verfahren gemäß Anspruch 13, umfassend die Ausführung wenigstens einer Feldplatte, umfassend einen dritten horizontalen Abschnitt (83₁) der elektrisch leitenden Schicht (8).

## Claims

1. Integrated electronic device comprising:
- a Schottky diode (2) comprising an anode and a cathode mutually coupled by a two-dimensional electron gas (72) and having a first threshold voltage (Vs1),
- a derivation component (3) having a second threshold voltage (Vs2) greater than the first threshold voltage (Vs1) and coupled in parallel with the Schottky diode,
the device being **characterised in that** the derivation component (3) is a lateral super-junction transistor comprising an insulated vertical gate (9), a source electrically connected to the anode of the Schottky diode (2) and a drain electrically connected to the cathode of the Schottky diode (2), the insulated vertical gate (9) and the source being mutually electrically coupled so as to be at the same electrical potential.

2. Device according to claim 1, comprising an electrically conductive layer (8), the insulated vertical gate (9) comprising a first vertical portion (80) of the electrically conductive layer (8), said first portion (80) being electrically insulated from the super-junction (5) by a dielectric layer (90), the source of the transistor (3) comprising a second portion (81) of said electrically conductive layer (8).

3. Device according to claim 2, wherein the anode of the Schottky diode (2) comprises the second portion (81) of the electrically conductive layer (8).

4. Device according to one of claims 2 and 3, wherein the device comprises a heterojunction (7) arranged on the super-junction (5) and comprising a first junction layer (70) and a second junction layer (71), the two-dimensional electron gas (72) being formed at the interface between the first junction layer (70) and the second junction layer (71).

5. Device according to claim 4, wherein the second portion (81) of the electrically conductive layer (8) forms a Schottky contact (82) with the two-dimensional electron gas (72), at a distance from the ends of the first junction layer (70).

6. Device according to any one of claims 2 to 5, comprising at least one field plate comprising a horizontal portion (83₁) of the electrically conductive layer (8).

7. Device according to any one of claims 1 to 6, wherein:
- the drain of the transistor (3) comprises a heavily doped semiconductor region (6) of a first conductivity type;
- the super-junction (5) comprises a vertical stack of an alternation of semiconductor layers of the first conductivity type (50) and of semiconductor layers of a second conductivity type (51) opposite to the first conductivity type; and
- the first and second layers (50, 51) extend horizontally from the heavily doped semiconductor region (6) up to the insulated vertical gate (9).

8. Device according to claim 7, wherein the super-junction (5) comprises an alternation of five first layers (50) N type doped at a concentration of 4×10¹⁸ cm⁻³ and of five second layers (51) P type doped at a concentration of 4×10¹⁸ cm⁻³, the first and second layers (50, 51) each having a thickness equal to 150 nm.

9. Device according to claim 8, wherein the super-junction (5) is arranged on a voltage withstand layer (14) of thickness equal to 3 µm and N type doped at a concentration of 1×10¹⁶ cm⁻³.

10. Device according to one of claims 7 to 9, wherein the cathode of the Schottky diode (2) comprises an electrically conductive layer (CE) in ohmic contact with the heavily doped semiconductor region (6) and the two-dimensional electron gas (72).

11. Method for manufacturing an integrated electronic device comprising the following steps:
- a formation of a Schottky diode (2) comprising an anode and a cathode mutually coupled by a two-dimensional electron gas (72), the Schottky diode (2) having a first threshold voltage (Vs1);
- a formation of a derivation component (3) having a second threshold voltage (Vs2) greater than the first threshold voltage (Vs1), the derivation component (3) being a lateral super-junction transistor comprising an insulated vertical gate (9), a source and a drain, the insulated vertical gate (9) and the source being mutually electrically coupled so as to be at the same electrical potential;
- a parallel coupling of the derivation component (3) and the Schottky diode (2), the source of the transistor being electrically connected to the anode of the Schottky diode (2) and the drain of the transistor being electrically connected to the cathode of the Schottky diode (2).

12. Method according to claim 11, comprising:
- a production of the super-junction comprising a stack of an alternation of first semiconductor layers (50) of a first conductivity type and of second semiconductor layers (51) of a second conductivity type opposite to the first conductivity type,
- a production of a heavily doped semiconductor region (6) of the first conductivity type at a first end of the semiconductor layers,
- a production, on the super-junction, of a heterojunction comprising a production of a first junction layer (70) of a first semiconductor material and a production of a second junction layer (71) of a second semiconductor material on the first junction layer (70), the first and the second materials having different bandgaps so that the two-dimensional electron gas (72) is formed at the interface between the first junction layer (70) and the second junction layer (71),
- a production of an insulated vertical gate (9) at a second end of the semiconductor layers (50, 51),
- a production of the anode of the Schottky diode (2) by a formation of a first Schottky contact (82) with the two-dimensional electron gas (72) so that the first Schottky contact (82) and the insulated vertical gate (9) are mutually electrically coupled,
- a production of a second ohmic contact (60) with the two-dimensional electron gas (72) and the heavily doped semiconductor region (6).

13. Method according to claim 12, comprising a deposition of an electrically conductive layer (8), so that the insulated vertical gate (9) comprises a first portion (80) of the electrically conductive layer (8) and that the first Schottky contact (82) comprises a second portion (81) of the electrically conductive layer (8).

14. Method according to claim 13, comprising the production of at least one field plate comprising a third horizontal portion (83₁) of the electrically conductive layer (8).
